# EUROPEAN PATENT SPECIFICATION

(11) **EP 3 654 530 B1**
(45) Date of publication and mention of the grant of the patent: **24.11.2021**
(21) Application number: 19207072.0
(22) Date of filing: 05.11.2019
(51) Int. Cl.: H03K 17/06, H02M 1/08

(54) **LOW VOLTAGE DROP RECTIFIER**
GLEICHRICHTER MIT GERINGEM SPANNUNGSABFALL
REDRESSEUR À FAIBLE CHUTE DE TENSION

(30) Priority: 16.11.2018 US 201816193199
(43) Date of publication of application: 20.05.2020
(73) Proprietor: NXP B.V., 5656 AG Eindhoven (NL)
(72) Inventor: GENG, Xueyang, Redhill, Surrey RH1 1QZ (GB); VEMULA, Madan Mohan Reddy, Redhill, Surrey RH1 1QZ (GB); ANDERSON, Alma, Redhill, Surrey RH1 1QZ (GB)
(74) Representative: Hardingham, Christopher Mark

(56) References cited:
- US-A1- 2014 085 952
- US-A1- 2017 244 333

## Description

### Background

### Field

This disclosure relates generally to electronic circuits, and more specifically, to a low voltage drop rectifier.

### Related Art

Today, many electronic products, such as mobile devices and other small devices, incorporate single-wire communication systems to negotiate commands between host and slave devices. These devices and/or single-wire communication cables are required to be self-powered, especially in scenarios where a target device has a dead battery. However, such single-wire systems can be inefficient and susceptible to significant power loss. Therefore, a need exists for a single-wire system that improves efficiency and reduces loss.

United States patent application publication number US 2014/0085952 discloses a synchronous rectifier controller which includes a drive clamp adjust terminal, a drive terminal, a clamp voltage generator circuit coupled to the drive clamp adjust terminal for measuring a signal at the drivetime adjust terminal and providing a clamp voltage having a value determined by the signal, and a driver for providing a drive signal to the drive terminal at a voltage related to the clamp voltage during an active period of the drive signal.

United States patent application publication number US 2017/0244333 discloses a system for gate pre-provisioning for fast turn-off of a synchronous rectifier. The synchronous rectifier driver turns ON the synchronous rectifier by driving the gate at a high level for a period of time but is based on a previous conduction time of the synchronous rectifier. The synchronous rectifier driver thereafter drives the gate at a lower level that is sufficient to keep the synchronous rectifier ON. The synchronous rectifier can be quickly turned OFF by further reducing the level of the drive signal at the gate to discuss rectifier.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in simplified schematic diagram form, a prior art rectifier circuit.
FIG. 2 illustrates, in simplified schematic diagram form, an example low voltage drop rectifier.
FIG. 3 illustrates, in simplified schematic diagram form, an example implementation of a low voltage drop rectifier in accordance with an embodiment.
FIG. 4 illustrates, in simplified schematic diagram form, another example implementation of a low voltage drop rectifier in accordance with an embodiment.
FIG. 5 illustrates, in plot diagram form, an example simulation result of a low voltage drop rectifier implementation in accordance with an embodiment.

### Detailed Description

Generally, there is provided, a low voltage drop rectifier capable of providing a rectified power supply for a device of a one wire communication system. The low voltage rectifier is configured to efficiently generate power from virtually any switching signal. A comparator controls a pass transistor arranged in parallel with a rectifying diode. When the output voltage of the rectifier is higher than the input voltage, the comparator immediately turns off the pass transistor preventing back current and improving efficiency.

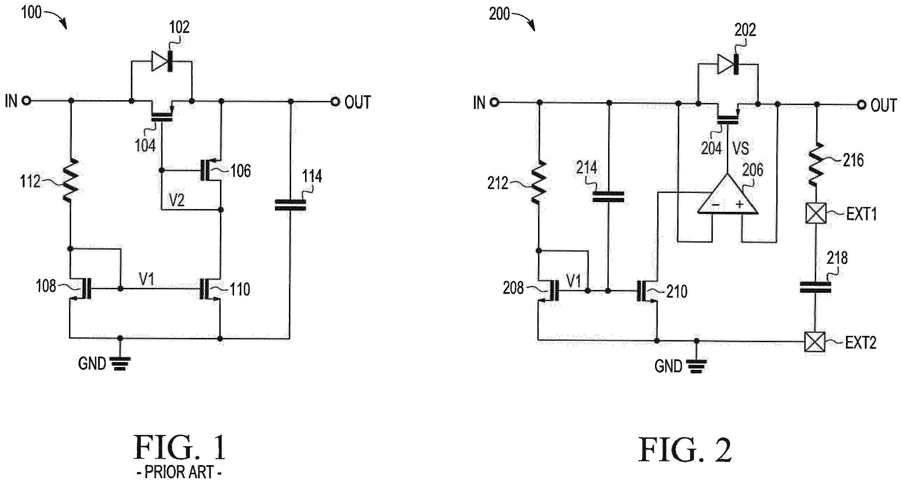

FIG. 1 illustrates, in simplified schematic diagram form, a prior art rectifier circuit 100. Circuit includes input and output terminals labeled IN and OUT respectively. A diode 102 has an anode terminal connected at the IN node and a cathode terminal connected at the OUT node. A first P-channel transistor 104 is connected in parallel with diode 102. A first current electrode of transistor 104 is connected at the IN node and a second current electrode of transistor 104 is connected at the OUT node. A second P-channel transistor 106 has a first current electrode connected at the OUT node and a second current electrode and a control electrode connected to a control electrode of transistor 104 at node labeled V2. A first N-channel transistor 108 has a first current electrode and a control electrode connected together at node labeled V1 and a second current electrode connected to ground (GND). A second N-channel transistor 110 has a first current electrode connected at node V2, a control electrode connected at node V1, and a second current electrode connected to ground. A resistor 112 has a first terminal connected at the IN node and a second terminal connected at node V1. A capacitor 114 has a first terminal connected at the OUT node and a second terminal connected to ground.

FIG. 2 illustrates, in simplified schematic diagram form, an example low voltage drop rectifier 200. Rectifier 200 is formed as an integrated circuit (IC) and includes a diode 202, a P-channel pass transistor 204, a voltage comparator 206, N-channel transistors 208-210, resistors 212 and 216, internal capacitor 214, along with external (e.g., off-chip) storage capacitor 218.

An anode terminal of diode 202 is coupled to a first current electrode of transistor 204 at an input node labeled IN. A cathode terminal of diode 202 is coupled to a second current electrode of transistor 204 at an output node labeled OUT. An inverting input of comparator 206 is coupled at the IN node and a non-inverting input of comparator 206 is coupled at the OUT node. An output of comparator 206 is coupled to a control electrode of transistor 204 at node labeled VS. Comparator 206 is configured to compare an input voltage at the IN node with an output voltage at the OUT node. A resulting output voltage signal at the output of comparator 206 is applied to the control electrode of transistor 204 to control on and off states of transistor 204. For example, when the input voltage is higher than the output voltage, the output voltage signal of comparator 206 is configured to cause transistor 204 to turn on (e.g., conductive state). When the input voltage is not higher than the output voltage, the output voltage signal of comparator 206 is configured to cause transistor 204 to immediately turn off (e.g., non-conductive state preventing back current and improving overall efficiency.

A bias circuit is formed in a current mirror configuration of transistors 208 and 210. A first current electrode of transistor 208 is coupled to a voltage supply terminal labeled GND. A second current electrode and a control electrode of transistor 208 are coupled together at node labeled V1. The GND terminal may also be referred to as a ground voltage supply terminal. A first current electrode of transistor 210 is coupled at the GND terminal and a control electrode of transistor 210 is coupled at node V1. A second current electrode of transistor 210 is coupled to generate a bias current in comparator 206.

A first resistor 212 is coupled between the IN node and transistor 208 and is configured to limit or adjust the bias current. A first terminal of resistor 212 is coupled at the IN node and a second terminal of resistor 212 is coupled at node V1. A first capacitor 214 is coupled between the input IN node and transistor 208. The capacitor 214 is configured to couple a rising edge of the input voltage signal at the IN node to speed up the turn-on of transistor 204. A first terminal of capacitor 214 is coupled at the IN node and a second terminal of capacitor 214 is coupled at node V1.

A second resistor 216 is coupled between the OUT node and a first external terminal labeled EXT1. The second resistor 216 is configured to limit or adjust in-rush current to a second capacitor 218. A first terminal of resistor 216 is coupled at the OUT node and a second terminal of resistor 216 is coupled at the EXT1 terminal. The second capacitor 218 is coupled between the EXT1 terminal and the ground voltage supply terminal. The capacitor 218 is located external (e.g., off-chip) from the IC and is configured to serve as a storage capacitor. A first terminal of capacitor 218 is coupled at the EXT1 and a second terminal of capacitor 218 is coupled at a second external terminal labeled EXT2. In this embodiment, the EXT2 terminal provides electrical connection to the GND terminal.

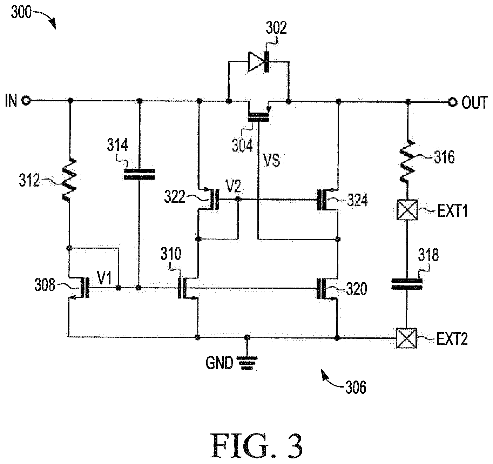

FIG. 3 illustrates, in simplified schematic diagram form, an example implementation of a low voltage drop rectifier 300 in accordance with an embodiment. Rectifier 300 is formed as an IC and includes a diode 302, a P-channel pass transistor 304, a voltage comparator circuit 306, N-channel bias transistor 308, resistors 312 and 316, internal capacitor 314, along with external storage capacitor 318.

An anode terminal of diode 302 is coupled to a first current electrode of transistor 304 at an input node labeled IN. A cathode terminal of diode 302 is coupled to a second current electrode of transistor 304 at an output node labeled OUT. Comparator circuit 306 includes P-channel transistors 322-324 and N-channel transistors 310 and 320. A first current electrode of transistor 322 is coupled at the IN node and serves as an inverting input of comparator circuit 306. A second current electrode of transistor 322 is coupled to a first current electrode of transistor 310 and control electrodes of transistors 322 and 324 at node labeled V2. A first current electrode of transistor 324 is coupled at the OUT node and serves as a non-inverting input of comparator circuit 306. A second current electrode of transistor 324 is coupled to a first current electrode of transistor 320 and a control electrode of transistor 304 at output node of comparator circuit 306 labeled VS. A second current electrode of transistor 310 and a second current electrode of transistor 320 are coupled to voltage supply terminal labeled GND. The GND terminal may also be referred to as a ground voltage supply terminal.

Bias transistor 308 and transistors 310 and 320 are configured to form a current mirror and generate a bias current in the comparator circuit 306. A first current electrode of transistor 308 is coupled to the GND terminal. A second current electrode and a control electrode of transistor 308 are coupled to control electrodes of transistors 310 and 320 at node labeled V1. In this configuration, when transistors 308, 310, and 320 all have similar size dimensions, a same current will flow through each of transistors 308, 310, and 320.

A first resistor 312 is coupled between the IN node and transistor 308 and is configured to limit or adjust the bias current. A first terminal of resistor 312 is coupled at the IN node and a second terminal of resistor 312 is coupled at node V1. A first capacitor 314 is coupled between the input IN node and transistor 308. The capacitor 314 is configured to couple a rising edge of the input voltage signal at the IN node to speed up the turn-on of transistor 304. A first terminal of capacitor 314 is coupled at the IN node and a second terminal of capacitor 314 is coupled at node V1.

A second resistor 316 is coupled between the OUT node and a first external terminal labeled EXT1. The second resistor 316 is configured to limit or adjust in-rush current to a second capacitor 318. A first terminal of resistor 316 is coupled at the OUT node and a second terminal of resistor 316 is coupled at the EXT1 terminal. The second capacitor 318 is coupled between the EXT1 terminal and the ground voltage supply terminal. The capacitor 318 is located external from the IC and is configured to serve as a voltage storage capacitor. A first terminal of capacitor 318 is coupled at the EXT1 and a second terminal of capacitor 318 is coupled at a second external terminal labeled EXT2. In this embodiment, the EXT2 terminal provides electrical connection to the GND terminal.

In this embodiment, comparator circuit 306 is configured to compare an input voltage at the IN node with an output voltage at the OUT node. A resulting output voltage signal at the output of comparator 306 is applied to the control electrode of transistor 304 to control conductive states of transistor 304. For example, when the input voltage is higher than the output voltage, the output voltage signal of comparator 306 is configured to cause transistor 304 to turn on (e.g., conductive state), and when the input voltage is not higher than the output voltage, the output voltage signal of comparator 306 is configured to cause transistor 304 to turn off (e.g., non-conductive state).

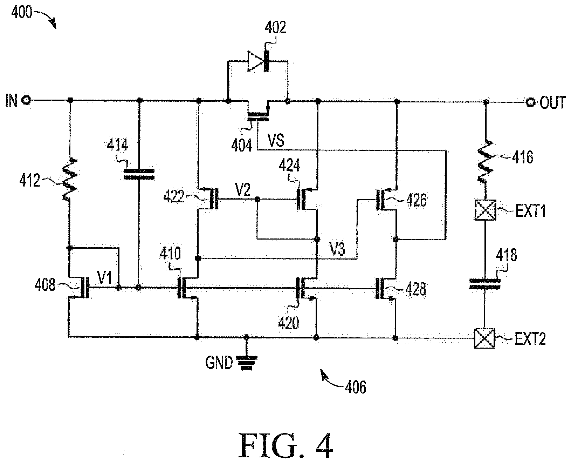

FIG. 4 illustrates, in simplified schematic diagram form, another example implementation of a low voltage drop rectifier 400 in accordance with an embodiment. Rectifier 400 is formed as an IC and includes a diode 402, a P-channel pass transistor 404, a two-stage voltage comparator circuit 406, N-channel bias transistor 408, resistors 412 and 416, internal capacitor 414, along with external storage capacitor 418.

An anode terminal of diode 402 is coupled to a first current electrode of transistor 404 at an input node labeled IN. A cathode terminal of diode 402 is coupled to a second current electrode of transistor 404 at an output node labeled OUT. A first stage of comparator circuit 406 includes P-channel transistors 422-424 and N-channel transistors 410 and 420. A first current electrode of transistor 422 is coupled at the IN node and serves as a non-inverting input of comparator circuit 406. A second current electrode of transistor 422 is coupled to a first current electrode of transistor 410 and a control electrode of transistor 426 at a first stage output node labeled V3. A first current electrode of transistor 424 is coupled at the OUT node and serves as an inverting input of comparator circuit 406. A second current electrode and a control electrode of transistor 424 are coupled to a first current electrode of transistor 420 and a control electrode of transistor 422 at node labeled V2. A second current electrode of transistor 410 and a second current electrode of transistor 420 are coupled to the voltage supply terminal labeled GND. The GND terminal may also be referred to as a ground voltage supply terminal.

A second stage of comparator circuit 406 includes P-channel transistor 426 and N-channel transistor 428. A first current electrode of transistor 426 is coupled at the OUT node and a second current electrode of transistor 426 is coupled to a first current electrode of transistor 428 and a control electrode of transistor 404 at output node of comparator circuit 406 labeled VS. A second current electrode of transistor 428 is coupled to the GND terminal.

Bias transistor 408 is configured to form current mirrors with each of transistors 410, 420, and 428 to generate a bias current in the comparator circuit 406. A first current electrode of transistor 408 is coupled to the GND terminal. A second current electrode and a control electrode of transistor 408 are coupled to control electrodes of transistors 410, 420, and 428 at node labeled V1. In this configuration, when transistors 408, 410, 420, and 428 all have similar size dimensions, a same current will flow through each of transistors 408, 410, 420, and 428.

A first resistor 412 is coupled between the IN node and transistor 408 and is configured to limit or adjust the bias current. A first terminal of resistor 412 is coupled at the IN node and a second terminal of resistor 412 is coupled at node V1. A first capacitor 414 is coupled between the input IN node and transistor 408. The capacitor 414 is configured to couple a rising edge of the input voltage signal at the IN node to speed up the turn-on of transistor 404. A first terminal of capacitor 414 is coupled at the IN node and a second terminal of capacitor 414 is coupled at node V1.

A second resistor 416 is coupled between the OUT node and a first external terminal labeled EXT1. The second resistor 416 is configured to limit or adjust in-rush current to a second capacitor 418. A first terminal of resistor 416 is coupled at the OUT node and a second terminal of resistor 416 is coupled at the EXT1 terminal. The second capacitor 418 is coupled between the EXT1 terminal and the ground voltage supply terminal. The capacitor 418 is located external from the IC and is configured to serve as a voltage storage capacitor. A first terminal of capacitor 418 is coupled at the EXT1 and a second terminal of capacitor 418 is coupled at a second external terminal labeled EXT2. In this embodiment, the EXT2 terminal provides electrical connection to the GND terminal.

In this embodiment, comparator circuit 406 is configured to compare an input voltage at the IN node with an output voltage at the OUT node and provide higher gain. A resulting output voltage signal at the output of comparator 406 is applied to the control electrode of transistor 404 to control conductive states of transistor 404. For example, when the input voltage is higher than the output voltage, the output voltage signal of comparator 406 is configured to cause transistor 404 to turn on (e.g., conductive state), and when the input voltage is not higher than the output voltage, the output voltage signal of comparator 406 is configured to cause transistor 404 to turn off (e.g., non-conductive state).

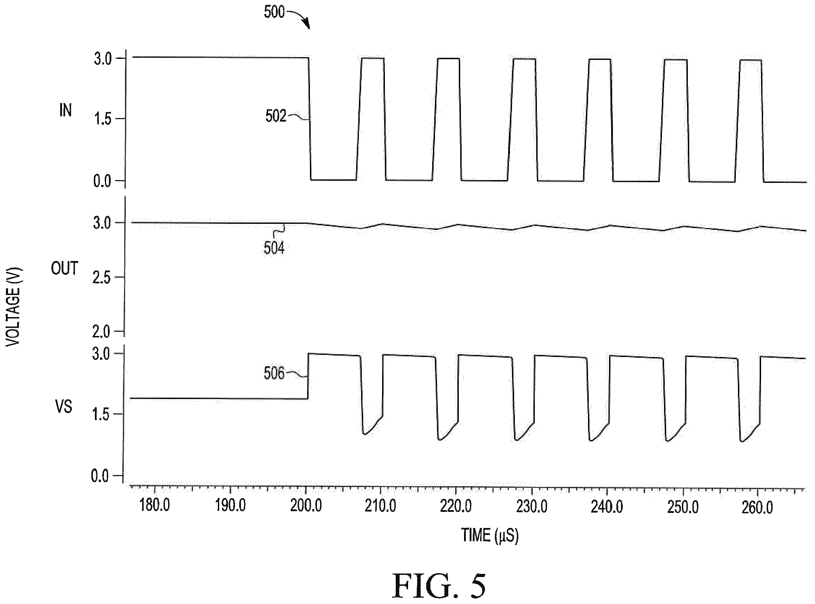

FIG. 5 illustrates, in plot diagram form, an example simulation result of low voltage drop rectifier 300 of FIG. 3 in accordance with an embodiment. The plot diagram 500 includes an input voltage signal IN waveform 502 corresponding to a simulation stimulus voltage signal at the IN node, an output voltage signal OUT waveform 504 depicting a simulation response voltage signal at the OUT node, and a control voltage signal VS waveform 506 depicting to a simulation response voltage signal at the control electrode of transistor 304 (e.g., VS node). The IN waveform and simulation response waveforms OUT and VS are shown with time values in microseconds (µS) on the X-axis and voltage values in volts on the Y-axis. By way of example, operation of the rectifier 300 is depicted in the following.

The rectifier 300 is self-powered based on the IN signal which swings between 3.0 volts and 0.0 volts in this embodiment, for example. The IN signal begins to transition from a high level (e.g., -3.0 volts) to a low level (e.g., -0.0 volts) at approximately 200 µS. In turn, the OUT signal begins to decay. While the voltage at the OUT node is higher than the voltage at the IN node, the comparator output signal at the VS node is at a logic high level, turning off pass transistor 304.

At approximately 206 µS of plot diagram 500, the IN signal begins to transition from a low level (e.g., -0.0 volts) to a high level (e.g., -3.0 volts). Because the voltage at the OUT node decayed (e.g., -100 millivolts) to a voltage level lower than the voltage at the IN node (e.g., -3.0 volts), the resulting comparator output signal at the VS node turns on pass transistor 304 and charges the storage capacitor. While the voltage at the IN node is higher than the voltage at the OUT node, the VS signal is sufficient to keep pass transistor 304 conducting.

At approximately 210 µS of plot diagram 500, the cycle repeats as the IN signal again transitions from a high level (e.g., -3.0 volts) to a low level (e.g., -0.0 volts). At this point, the OUT signal is at a higher voltage level than the IN signal. While the voltage at the IN node is lower than the voltage at the OUT node, the VS signal is sufficient to keep pass transistor 304 non-conducting.

Generally, there is provided, a rectifier circuit including a diode having a first terminal coupled at an input node and a second terminal coupled at an output node; a first transistor having a first current electrode coupled at the input node and a second current electrode coupled at the output node; a comparator circuit having a first input coupled at the input node, a second input coupled at the output node, and an output coupled to a control electrode of the first transistor; and a bias circuit coupled to the comparator circuit, the bias circuit configured to generate a bias current in the comparator circuit. The circuit may further include a resistor having a first terminal coupled at the input node and a second terminal coupled to the bias circuit. The circuit may further include a capacitor having a first terminal coupled at the input node and a second terminal coupled to the bias circuit. The transistor may be characterized as a P-channel MOS field effect transistor. The comparator circuit does include a second transistor having a first current electrode coupled at the input node; a third transistor having a first current electrode coupled at a second current electrode and a control electrode of the second transistor at a first node; a fourth transistor having a first current electrode coupled at the output node and a control electrode coupled at the first node; and a fifth transistor having a first current electrode coupled at the second current electrode of the fourth transistor and the control electrode of the first transistor at a second node. The bias circuit may include a sixth transistor coupled to the third and fifth transistors in a current mirror configuration, the sixth transistor having a first current electrode and a control electrode coupled to a control electrode of the third and fifth transistors at a third node. The third, fifth, and sixth transistors may be configured to have approximately the same width dimension. The circuit may further include an external capacitor coupled between the output node and a first voltage supply. The circuit may further include a resistor having a first terminal coupled at the output node and a second terminal coupled to a first terminal of the external capacitor.

In another embodiment, there is provided, a rectifier circuit including a diode having an anode terminal coupled at an input node and a cathode terminal coupled at an output node; a first transistor having a first current electrode coupled at the input node and a second current electrode coupled at the output node; a comparator circuit having a first input coupled at the input node, a second input coupled at the output node, and an output coupled to a control electrode of the first transistor; and a bias circuit coupled to the comparator circuit, the bias circuit configured to generate a bias current in the comparator circuit. The comparator circuit does include a second transistor having a first current electrode coupled at the input node; a third transistor having a first current electrode coupled at a second current electrode and a control electrode of the second transistor at a first node; a fourth transistor having a first current electrode coupled at the output node and a control electrode coupled at the first node; and a fifth transistor having a first current electrode coupled at the second current electrode of the fourth transistor and the control electrode of the first transistor at a second node. The comparator circuit may be configured as a two-stage comparator, a first stage of the two-stage comparator may include a second transistor having a first current electrode coupled at the input node; a third transistor having a first current electrode coupled to a second current electrode of the second transistor at a first node, and second current electrode coupled at a first voltage supply; a fourth transistor having a first current electrode coupled at the output node, and a second current electrode and a control electrode coupled to a control electrode of the second transistor at a second node; and a fifth transistor having a first current electrode coupled to the second current electrode of the fourth transistor at the second node, and a second current electrode coupled at the first voltage supply. The bias circuit may include a sixth transistor coupled to the third and fifth transistors in a current mirror configuration, the sixth transistor having a first current electrode and a control electrode coupled to a control electrode of the third and fifth transistors at a third node and a second current electrode coupled at the first voltage supply. A second stage of the two-stage comparator may include a sixth transistor having a first current electrode coupled at the output node and a control electrode coupled at the first node; and a seventh transistor having a first current electrode coupled at a second current electrode of the sixth transistor and the control electrode of the first transistor, a control electrode coupled to the control electrodes of the third and fifth transistors, and a second current electrode coupled at the first voltage supply. The circuit may further include an external capacitor coupled between the output node and a first voltage supply. The circuit may further include a resistor having a first terminal coupled at the output node and a second terminal coupled to a first terminal of the external capacitor. The circuit may further include a capacitor having a first terminal coupled at the input node and a second terminal coupled to the bias circuit.

In yet another embodiment, there is provided, a rectifier circuit including a diode having an anode terminal coupled at an input node and a cathode terminal coupled at an output node; a first transistor having a first current electrode coupled at the input node and a second current electrode coupled at the output node; a second transistor having a first current electrode and a control electrode coupled together at a first node and a second current electrode coupled at first voltage supply; and a comparator circuit coupled to the first node, the comparator circuit having a first input coupled at the input node, a second input coupled at the output node, and an output coupled to a control electrode of the first transistor. The comparator circuit does include a third transistor having a first current electrode coupled at the input node; a fourth transistor having a first current electrode coupled to a second current electrode and a control electrode of the third transistor, and a control electrode coupled at the first node; a fifth transistor having a first current electrode coupled at the output node and a control electrode coupled to the control electrode of the third transistor at a second node; and a sixth transistor having a first current electrode coupled to a second current electrode of the fifth transistor and the control electrode of the first transistor at a third node, and a control electrode coupled at the first node. The circuit may further include a capacitor having a first terminal coupled at the input node and a second terminal coupled at the first node.

By now it should be appreciated that there has been provided, a low voltage drop rectifier capable of providing a rectified power supply for a device of a one wire communication system. The low voltage rectifier is configured to efficiently generate power from virtually any switching signal. A comparator controls a pass transistor arranged in parallel with a rectifying diode. When the output voltage of the rectifier is higher than the input voltage, the comparator immediately turns off the pass transistor preventing back current and improving efficiency.

Because the apparatus implementing the present invention is, for the most part, composed of electronic components and circuits known to those skilled in the art, circuit details will not be explained in any greater extent than that considered necessary as illustrated above, for the understanding and appreciation of the underlying concepts of the present invention and in order not to obfuscate or distract from the teachings of the present invention.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. A rectifier circuit comprising:
a diode (202) having a first terminal coupled at an input node and a second terminal coupled at an output node;
a first transistor (204) having a first current electrode coupled at the input node and a second current electrode coupled at the output node;
a comparator (206) circuit having a first input coupled at the input node, a second input coupled at the output node, and an output coupled to a control electrode of the first transistor; and
a bias circuit coupled to the comparator circuit, the bias circuit configured to generate a bias current in the comparator circuit; **characterized in that** the comparator circuit further comprises:
a second transistor (322) having a first current electrode coupled at the input node and having a control electrode coupled at a first node (V2);
a third transistor (310) having a first current electrode coupled at a second current electrode of the second transistor and at the first node (V2) and having a control electrode coupled to a second node (V1);
a fourth transistor (324) having a first current electrode coupled at the output node and a control electrode coupled at the first node; and
a fifth transistor (320) having a first current electrode coupled at the second current electrode of the fourth transistor and at the control electrode of the first transistor and having a control electrode coupled to the second node (V1).

2. The circuit of claim 1, further comprising a resistor (212) having a first terminal coupled at the input node and a second terminal coupled to the bias circuit.

3. The circuit of claim 1 or 2, further comprising a capacitor (214) having a first terminal coupled at the input node and a second terminal coupled to the bias circuit.

4. The circuit of any preceding claim, wherein the first transistor is characterized as a P-channel MOS field effect transistor.

5. The circuit of any preceding claim, wherein the comparator circuit is configured as a two-stage comparator, a first stage of the two-stage comparator comprising:
the second transistor;
the third transistor;
the fourth transistor; and
the fifth transistor.

6. The circuit of any preceding claim, wherein the bias circuit comprises a sixth transistor (308) coupled to the third and fifth transistors in a current mirror configuration, the sixth transistor having a first current electrode and a control electrode coupled to a control electrode of the third and fifth transistors at a third node.

7. The circuit of claim 6, wherein a second stage of the two-stage comparator comprises:
the sixth transistor; and
the seventh transistor.

8. The circuit of claim 6 or 7, wherein the third, fifth, and sixth transistors are configured to have approximately the same width dimension.

9. The circuit of any preceding claim, further comprising an external capacitor coupled between the output node and a first voltage supply.

10. The circuit of claim 9, further comprising a resistor having a first terminal coupled at the output node and a second terminal coupled to a first terminal of the external capacitor.

## Patentansprüche

1. Gleichrichterschaltung, umfassend:
eine Diode (202) mit einem an einen Eingangsknoten gekoppelten ersten Anschluss und einem an einem Ausgangsknoten gekoppelten zweiten Anschluss;
einen ersten Transistor (204) mit einer an den Eingangsknoten gekoppelten ersten Stromelektrode und einer an den Ausgangsknoten gekoppelten zweiten Stromelektrode;
eine Vergleicher(206)-Schaltung mit einem an den Eingangsknoten gekoppelten ersten Eingang, einem an den Ausgangsknoten gekoppelten zweiten Eingang und einem an eine Steuerelektrode des ersten Transistors gekoppelten Ausgang; und
eine an die Vergleicherschaltung gekoppelte Biasschaltung, wobei die Biasschaltung ausgelegt ist zum Erzeugen eines Biasstroms in der Vergleicherschaltung; **dadurch gekennzeichnet, dass** die Vergleicherschaltung weiter umfasst:
einen zweiten Transistor (322) mit einer an den Eingangsknoten gekoppelten ersten Stromelektrode und einer an einen ersten Knoten (V2) gekoppelten Steuerelektrode;
einen dritten Transistor (310) mit einer an eine zweite Stromelektrode des zweiten Transistors und an den ersten Knoten (V2) gekoppelten ersten Stromelektrode und mit einer an einen zweiten Knoten (V1) gekoppelten Steuerelektrode;
einen vierten Transistor (324) mit einer an den Ausgangsknoten gekoppelten ersten Stromelektrode und einer an den ersten Knoten gekoppelten Steuerelektrode; und
einen fünften Transistor (320) mit einer an die zweite Stromelektrode des vierten Transistors und an die Steuerelektrode des ersten Transistors gekoppelten ersten Stromelektrode und einer an den zweiten Knoten (V1) gekoppelten Steuerelektrode.

2. Faltung nach Anspruch 1, weiter umfassend einen Widerstand (212) mit einem an den Eingangsknoten gekoppelten ersten Anschluss und einem an die Biasschaltung gekoppelten zweiten Anschluss.

3. Schaltung nach Anspruch 1 oder 2, weiter umfassend einen Kondensator (214) mit einem an den Eingangsknoten gekoppelten ersten Anschluss und einen an die Biasschaltung gekoppelten zweiten Anschluss.

4. Schaltung nach einem vorhergehenden Anspruch, wobei der erste Transistor als ein P-Kanal-MOS-Feldeffekttransistor gekennzeichnet ist.

5. Schaltung nach einem vorhergehenden Anspruch, wobei die Vergleicherschaltung als ein zweistufiger Vergleicher ausgelegt ist, eine erste Stufe des zweistufigen Vergleichers umfasst:
den zweiten Transistor;
den dritten Transistor;
den vierten Transistor; und
den fünften Transistor.

6. Schaltung nach einem vorhergehenden Anspruch, wobei die Biasschaltung einen an den dritten und fünften Transistor in einer Stromspiegelkonfiguration gekoppelten sechsten Transistor (308) umfasst, wobei der sechste Transistor eine erste Stromelektrode und eine Steuerelektrode, an eine Steuerelektrode des dritten und fünften Transistors an einem dritten Knoten gekoppelt, aufweist.

7. Schaltung nach Anspruch 6, wobei eine zweite Stufe des zweistufigen Vergleichers umfasst:
den sechsten Transistor; und
den siebten Transistor.

8. Schaltung nach Anspruch 6 oder 7, wobei der dritte, fünfte und sechste Transistor so ausgelegt sind, dass sie etwa die gleiche Breitenabmessung aufweisen.

9. Schaltung nach einem vorhergehenden Anspruch, weiter umfassend einen externen Kondensator, der zwischen den Ausgangsknoten und eine erste Spannungsversorgung gekoppelt ist.

10. Schaltung nach Anspruch 9, weiter umfassend einen Widerstand mit einem an den Ausgangsknoten gekoppelten ersten Anschluss und einem an einen ersten Anschluss des externen Kondensators gekoppelten zweiten Anschluss.

## Revendications

1. Circuit redresseur comprenant :
une diode (202) ayant une première borne couplée à un nœud d'entrée et une deuxième borne couplée à un nœud de sortie ;
un premier transistor (204) ayant une première électrode de courant couplée au nœud d'entrée et une deuxième électrode de courant couplée au nœud de sortie ;
un circuit comparateur (206) ayant une première entrée couplée au nœud d'entrée, une deuxième entrée couplée au nœud de sortie, et une sortie couplée à une électrode de commande du premier transistor ; et
un circuit de polarisation couplé au circuit comparateur, le circuit de polarisation étant configuré pour générer un courant de polarisation dans le circuit comparateur ; **caractérisé en ce que** le circuit comparateur comprend en outre :
un deuxième transistor (322) ayant une première électrode de courant couplée au nœud d'entrée et ayant une électrode de commande couplée à un premier nœud (V2) ;
un troisième transistor (310) ayant une première électrode de courant couplée à une deuxième électrode de courant du deuxième transistor et au premier nœud (V2) et ayant une électrode de commande couplée à un deuxième nœud (V1) ;
un quatrième transistor (324) ayant une première électrode de courant couplée au nœud de sortie et une électrode de commande couplée au premier nœud ; et
un cinquième transistor (320) ayant une première électrode de courant couplée à la deuxième électrode de courant du quatrième transistor et à l'électrode de commande du premier transistor, et ayant une électrode de commande couplée au deuxième nœud (V1).

2. Circuit selon la revendication 1, comprenant en outre une résistance (212) ayant une première borne couplée au nœud d'entrée et une deuxième borne couplée au circuit de polarisation.

3. Circuit selon la revendication 1 ou 2, comprenant en outre un condensateur (214) ayant une première borne couplée au nœud d'entrée et une deuxième borne couplée au circuit de polarisation.

4. Circuit selon l'une quelconque des revendications précédentes, dans lequel le premier transistor est caractérisé comme un transistor à effet de champ MOS à canal P.

5. Circuit selon l'une quelconque des revendications précédentes, dans lequel le circuit comparateur est configuré comme un comparateur à deux étages, un premier étage du comparateur à deux étages comprenant :
le deuxième transistor ;
le troisième transistor ;
le quatrième transistor ; et
le cinquième transistor.

6. Circuit selon l'une quelconque des revendications précédentes, dans lequel le circuit de polarisation comprend un sixième transistor (308) couplé aux troisième et cinquième transistors dans une configuration de miroir de courant, le sixième transistor ayant une première électrode de courant et une électrode de commande couplée à une électrode de commande des troisième et cinquième transistors au niveau d'un troisième nœud.

7. Circuit selon la revendication 6, dans lequel un deuxième étage du comparateur à deux étages comprend :
le sixième transistor ; et
le septième transistor.

8. Circuit selon la revendication 6 ou 7, dans lequel les troisième, cinquième et sixième transistors sont configurés pour avoir approximativement la même dimension en largeur.

9. Circuit selon l'une quelconque des revendications précédentes, comprenant en outre un condensateur externe couplé entre le nœud de sortie et une première alimentation en tension.

10. Circuit selon la revendication 9, comprenant en outre une résistance ayant une première borne couplée au nœud de sortie et une deuxième borne couplée à une première borne du condensateur externe.
